# EUROPEAN PATENT APPLICATION

(11) **EP 3 748 669 A1**
(43) Date of publication of application: **09.12.2020**
(21) Application number: 20177916.2
(22) Date of filing: 23.04.2015
(51) Int. Cl.: H01L 21/66

(54) **PREDICTIVE MODELING BASED FOCUS ERROR PREDICTION**

(30) Priority: 24.06.2014 US 201414313733
(62) Divisional of application: 15811731.7
(71) Applicant: Kla-Tencor Corporation, Milpitas, California 95035 (US)
(72) Inventor: VUKKADALA, Pradeep, Cupertino, CA 95014 (US); SINHA, Jaydeep, Livermore, CA 9455 (US)
(74) Representative: FRKelly

(57) **Abstract**

Wafer geometry measurement tools and methods for providing improved wafer geometry measurements are disclosed. Wafer front side, backside and flatness measurements are taken into consideration for semiconductor process control. The measurement tools and methods in accordance with embodiments of the present disclosure are suitable for handling any types of wafers, including patterned wafers, without the shortcomings of conventional metrology systems.

## Description

### CROSS-REFERENCE TO RELATED APPLICATIONS

The present application claims the benefit under 35 U.S.C. § 119(e) of U.S. Provisional Application Serial No. 61/982,731, filed April 22, 2014. Said U.S. Provisional Application Serial No. 61/982,731 is hereby incorporated by reference in its entirety.

### TECHNICAL FIELD

The disclosure generally relates to the field of semiconductors, and particularly to wafer geometry measurement techniques.

### BACKGROUND

Fabricating semiconductor devices typically includes processing a substrate such as a semiconductor wafer using a number of semiconductor fabrication processes. For example, lithography is a semiconductor fabrication process that involves transferring a pattern from a reticle to a resist arranged on a semiconductor wafer. Additional examples of semiconductor fabrication processes include, but are not limited to, chemical-mechanical polishing (CMP), etching, deposition, and ion implantation. Multiple semiconductor devices may be fabricated in an arrangement on a single semiconductor wafer and then separated into individual semiconductor devices.

Metrology processes are used at various steps during a semiconductor manufacturing process to monitor and control one or more semiconductor layer processes. Some of these characteristics include the flatness and thickness uniformity of the wafers. While conventional metrology systems may be able to monitor and control these characteristics, they are generally utilized for handling unpatterned/bare wafers. Therein lies a need for systems and methods for wafer geometry measurements suitable for any wafers, including patterned wafers, without the aforementioned shortcomings.

### SUMMARY

The present disclosure is directed to a method for monitoring and controlling a wafer polishing process. The method includes: obtaining a first set of wafer geometry measurements of a wafer prior to the wafer polishing process, the first set of wafer geometry measurements including: a first front side height measurement, a first backside height measurement, and a first wafer flatness measurement; optimizing the wafer polishing process for the wafer, wherein different pressure levels are assigned to different areas of the wafer to achieve a best-flatness condition, wherein the best-flatness condition for the wafer is calculated based on the first front side height measurement, the first backside height measurement and the first wafer flatness measurement obtained prior to the wafer polishing process; and polishing the wafer based on the optimized wafer polishing process.

A further embodiment of the present disclosure is directed to a method for analyzing process tool induced flatness errors. The method includes: obtaining wafer geometry measurements of a wafer, the wafer geometry measurements including at least: a front side height measurement and a backside height measurement; identifying front side wafer surface signatures based on the front side height measurement; identifying backside wafer surface signatures based on the backside height measurement; separating flatness errors induced by the front side wafer surface signatures from flatness errors induced by the backside wafer surface signatures; and determining whether a process tool induced flatness errors independently based on flatness errors induced by the front side wafer surface signatures and flatness errors induced by the backside wafer surface signatures.

An additional embodiment of the present disclosure is directed to a method for controlling lithography focus errors. The method includes: obtaining a first set of wafer geometry measurements of a wafer prior to lithography scanning, the first set of wafer geometry measurements including: a first front side height measurement, a first backside height measurement, and a first wafer flatness measurement; identifying at least one wafer flatness error; and controlling a lithography scanner to compensate for the at least one wafer flatness error during lithography scanning.

An additional embodiment of the present disclosure is directed to a method for calculating wafer variations. The method includes: obtaining a wafer-level thickness variation map; dividing the wafer-level thickness variation map into a plurality of uniform sized sites; independently leveling each site of the plurality of sites; further dividing each site into a plurality of rectangular areas, wherein each rectangular area generally corresponds to a slit-size of a lithography scanner; independently leveling each rectangular area of the plurality of rectangular areas for each site of the plurality of sites; and combining the plurality of rectangular areas of each site of the plurality of sites to obtain a full wafer measurement metric.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures in which:
FIG. 1 is an illustration depicting a wafer flatness measured on a patterned wafer geometry measurement tool;
FIG. 2 is an illustration depicting a wafer polishing process;
FIG. 3 is a block diagram depicting a wafer geometry measurement based control loop for a wafer polishing process;
FIG. 4 is block diagram depicting a wafer geometry measurement based control loop for a lithography scanner;
FIG. 5 is a flow diagram depicting a method for estimating flatness errors that takes flatness signatures of a lithography chuck into consideration;
FIG. 6 is an illustration depicting a site-based flatness variation calculation process;
FIG. 7 is an illustration that continues the depiction of the site-based flatness variation calculation process; and
FIG. 8 is an illustration that continues the depiction of the site-based flatness variation calculation process.

### DETAILED DESCRIPTION

Reference will now be made in detail to the subject matter disclosed, which is illustrated in the accompanying drawings.

Embodiments of the present disclosure are directed to systems and methods for providing improved wafer geometry measurements for lithography focus, CMP, and other semiconductor process control scanner corrections. It is noted that the term wafer geometry in the present disclosure refers to wafer front side height, backside height, thickness variation, flatness, and all consequent derivatives such as shape, topography, or the like. It is also noted that the systems and methods in accordance with embodiments of the present disclosure are suitable for handling any types of wafers, including patterned wafers, without the shortcomings of conventional metrology systems.

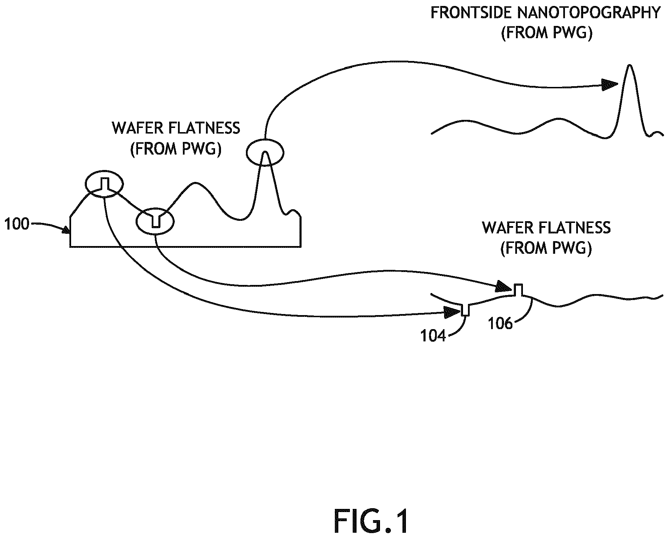

Referring to FIG. 1, a wafer flatness measured on a patterned wafer geometry (PWG) measurement tool is shown. A patterned wafer geometry measurement tool utilized in accordance with the present disclosure is a measurement tool that is able to measure front side height, back side height, and thickness variation of the wafer. Obtaining such information allows the sources of flatness errors to be separated and attributed to front side and backside components.

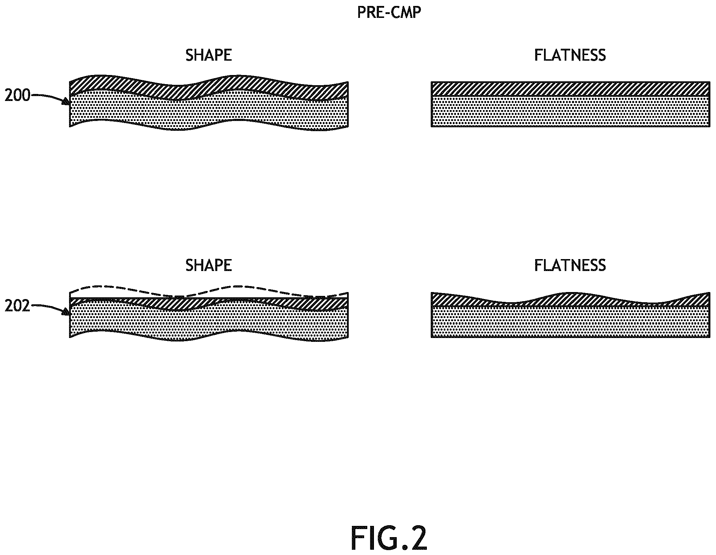

The ability to identify the sources of flatness errors is important. For instance, referring to FIG. 2, a simplified illustration depicting a wafer 200 being polished by a polishing tool (e.g., CMP) is shown. Suppose that the shape of the wafer 200 before going through the polishing process is slightly curved as shown, the polishing tool will then remove the raised portions of the top surface, resulting in a polished wafer 202 with a flat front side. However, this polished wafer 202 is undesirable because its flatness profile is suboptimal.

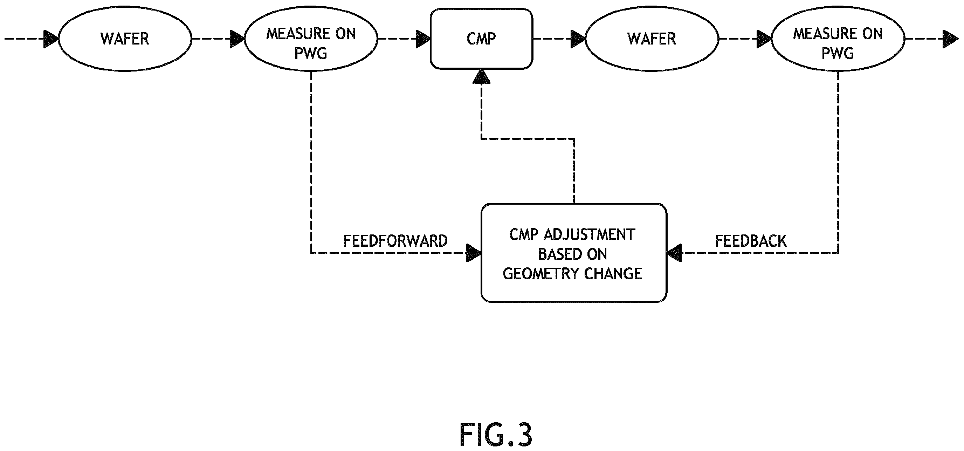

Instead of simply removing the raised portions of the top surface, wafer geometry and flatness data should be measured and taken into consideration for the polishing process. FIG. 3 is an illustration depicting such a control loop. More specifically, the separate front side and backside topography measurement data can be obtained and feed to the control loop to optimize the polishing process. For instance, the control loop may calculate a best-flatness condition that can be achieved if the wafer is polished in a certain manner. Subsequently, different pressure levels can be applied to different areas of the wafer so that the best-flatness condition can be achieved as an end result, as opposed to simply providing a flat top surface 202 as depicted in FIG. 2. In addition, wafer geometry measurements can be taken again after the polishing process; and adjustments necessary can be determined and applied to the polishing process accordingly.

It is contemplated that configuring the polishing tool in this manner to optimize for the best-flatness condition is beneficial for downstream processes. For example, a polished wafer will be held on a vacuum or a chuck using force when it is processed by a lithography process tool or the like. It is noted that when the wafer is held on a chuck using force, the wafer backside is expected to be substantially flattened, and if the wafer was simply polished to provide a flat top surface, the top surface may no longer be flat when the wafer is chucked. Focus errors may be introduced as a result. Since wafer flatness errors directly contribute to focus errors during lithography exposure, configuring the polishing tool based on optimizing flatness conditions as described above effectively improves focus of the lithography process tool.

It is also contemplated that when the wafer is chucked, features such as 104 and 106 (as shown in FIG. 1) that are induced by the wafer backside are pushed towards the front side and are presented to the lithography process tool along with the features that are induced by the wafer front side. While certain lithography process tools are capable of making adjustments based on wafer flatness to compensate for errors, it is noted that these adjustments are made without distinguishing between the front side induced flatness errors and the backside induced flatness errors. Therefore, adjustments made in this manner is not ideal because once the wafer is unchucked, compensations made while the wafer was chucked may turn out to be over-corrected or under-corrected.

With the ability to separate the front side topography from the backside topography, as shown in FIG. 1, the sources of flatness errors can be isolated. In the example shown in FIG. 1, once it is observed that the backside has distinct signatures (pin-type marks) 104 and 106, a subsequent process step may be notified of this observation (e.g., in a feedforward manner) and the subsequent process step may choose to compensate for (or avoid) such flatness errors accordingly.

In addition to providing a better compensation control mechanism, separating the front side topography from the backside topography can also help identifying process steps that may have caused front side and/or backside flatness errors during the manufacturing process. In the example shown in FIG. 1, once it is determined that the signatures (pin-type marks) 104 and 106 are induced by the backside, an analysis process may be invoked to find the cause of such signatures. In one embodiment, this analysis process (may be referred to as a cause analysis or root cause analysis) may attempt to identify which process step(s) during the manufacturing process caused these errors and by how much. For instance, this analysis process may take wafer geometry measurements at suspected process steps and identify the process step(s) that caused the backside signatures. It is contemplated that this process may also be utilized to analyze the front side errors as well without departing from the spirit and scope of the present disclosure.

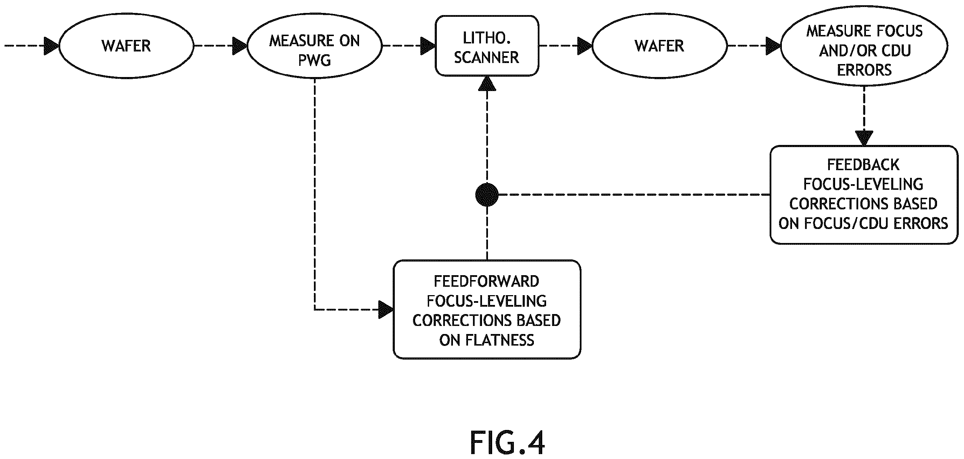

FIGS. 3 and 4 are illustrations depicting control loops that may be utilized to analyze/assess wafer geometry variations induced by various types of process steps. By measuring wafer geometry at two points, i.e., before and after a process of interest, the variations induced by that particular process step to wafer geometry can be assessed. The measured changes in wafer geometry may be related to impact on critical semiconductor fabrication parameters such as lithography focus and overlay errors, and yield by way of metrics such as site-flatness, in-plane displacement and the like that may be computed from the measured wafer geometry changes.

It is contemplated that such an analysis process may be utilized in every critical process steps during the manufacturing process to catch potential errors as soon as possible. Alternatively or additionally, this analysis process may be conditionally invoked when certain signatures are detected on either the front side or the backside. As previously mentioned, in the example shown in FIG. 1, when the signatures (pin-type marks) 104 and 106 are detected on the backside of the wafer 100, this detection may prompt further analysis to find the cause of such signatures. Furthermore, it may be configured to manually and/or automatically adjust process step conditions for a particular process tool and thereby minimize the impact of that particular process tool on wafer geometry and certain critical semiconductor fabrication parameters.

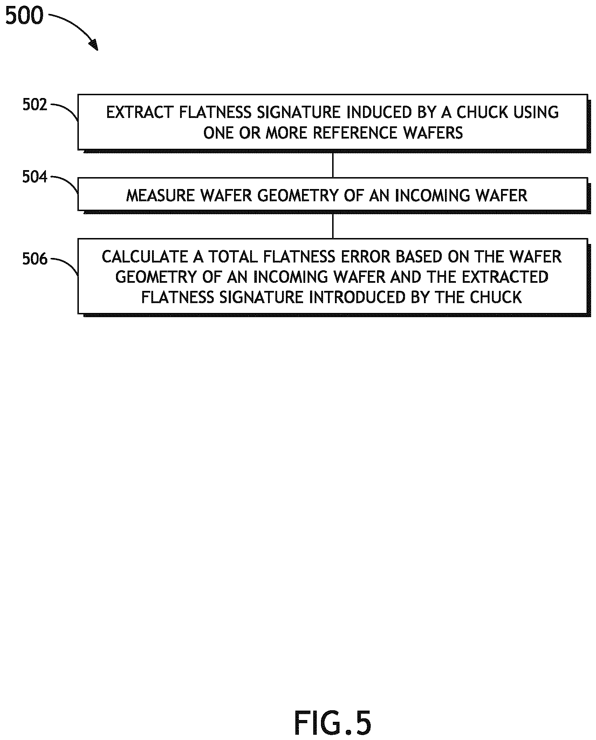

In addition to providing abilities to identify and to compensate for flatness errors, flatness signatures induced by a chuck can also be extracted and used to calculate/estimate a total flatness error of an incoming wafer. More specifically, FIG. 5 shows a methodology in which wafer flatness measurements obtained using a wafer geometry tool and scanner leveling measurements obtained from the lithography scanner can be used to calculate/estimate flatness errors. It is contemplated that patterned wafers or unpatterned bare wafers (serving as reference wafers) may be used to extract the flatness signature induced by a given chuck in step 502. Once the flatness signature of the given chuck has been extracted, total flatness errors during lithography exposures for future wafers chucked on that same chuck may be estimated. For example, when a new wafer is received, its wafer geometry, including its measured flatness, can be obtained in step 504 using a wafer geometry tool. Subsequently, by adding the extracted chuck flatness signature to the measured flatness of that wafer, the total flatness error (representing the flatness errors when the wafer is chucked) can be calculated in step 506. In this manner, the effects of forcing the wafer onto the chuck can be quantified (e.g., as a part of the feedforward control), which can help providing better focus leveling corrections.

It is noted that this calculation is also fully reversible. That is, if the height of the top surface is measured when the wafer is chucked on a particular chuck (e.g., based on scanner leveling measurements), and if the wafer geometry has been measured when the wafer was in an unchucked state, the flatness signature of that particular chuck can be calculated by subtracting the measured wafer geometry from the leveling map obtained from the lithography scanner. As previously mentioned, this process can be carried out using reference wafers in a controlled manner, and the extracted flatness signature of that particular chuck can be used to predict/estimate its effects on future wafers. In addition, the accuracy of this estimation process can be improved utilizing a feedback loop (e.g., as shown in FIG. 4). More specifically, focus error and/or critical dimension uniformity can be measured post-lithography to check how well the feedforward focus corrections worked. If it is determined that the feedforward alone did not sufficiently reduce focus and/or critical dimension uniformity errors, then the feedback loop may be employed that will adjust the focus corrections for the next wafer.

It is also contemplated that additional measurement metrics may also be obtained and provided as control signals. For instance, in one embodiment, a site-based flatness variation metric is obtained, which can be used to perform root cause analysis and/or provided as feedback to improve the manufacturing processes.

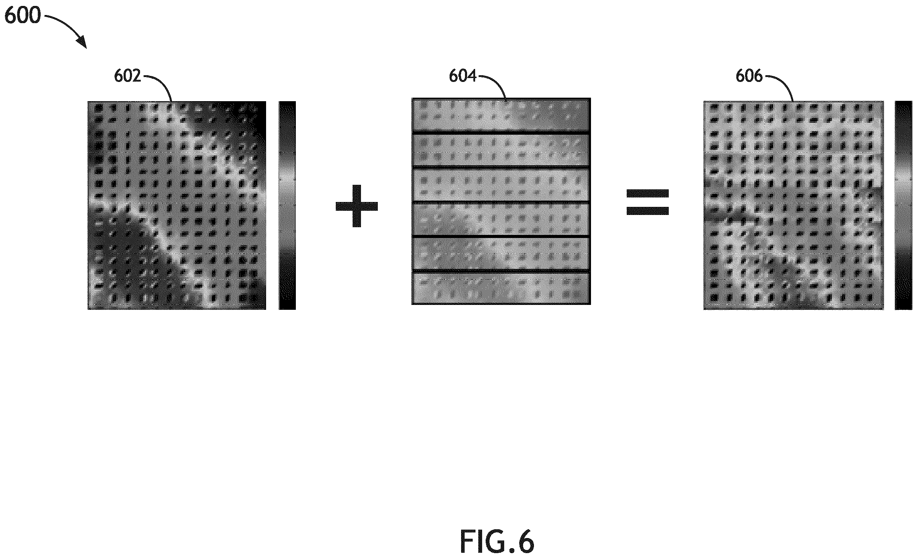

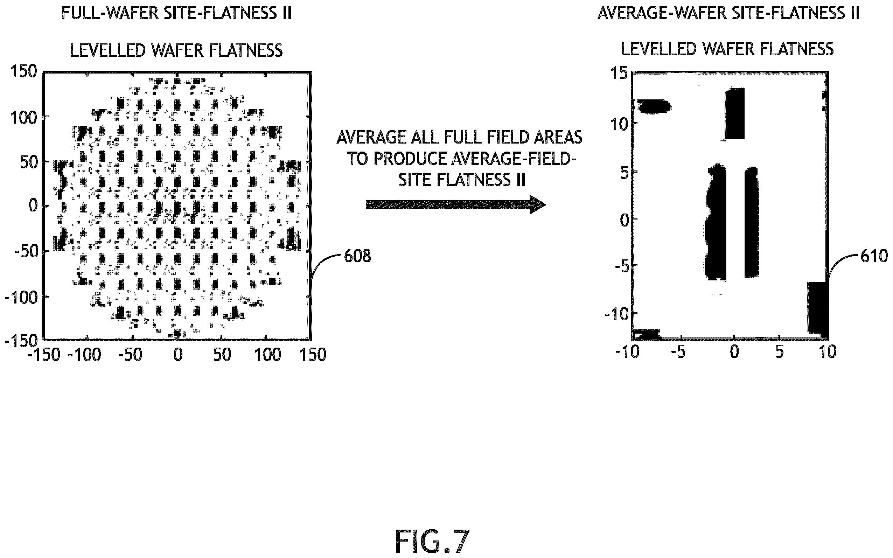

Referring to FIGS. 6 through 8, a series of illustrations depicting a site-based flatness variation calculation process 600 is shown. In step 602, a wafer-level thickness variation map is obtained and divided into a plurality of uniform sized sites (may also be referred to as fields). The thickness variation within each particular site is then leveled by fitting a single least-square best-fit plane to that particular site. In step 604, each site is further divided into rectangular areas generally equivalent to the slit-size of the lithography scanner. It is understood that if a site cannot be evenly divided by the slit-size, a partial slit may be utilized on one end of the site, or the slit-size may be slightly adjusted to evenly divide the site. It is noted that one of the advantages provided by dividing the sites in this manner is that it simulates the scanning process, which is done in a slit-by-slit manner.

Now, each slit-area can be further leveled independently by fitting a single least-square best-fit plane to that particular slit-area in step 606, and the independently leveled slit-areas within each site can be combined to form a full wafer map (e.g., representing industry standard metrics such as site frontside least squares focal plane, or SFQ and the like) in step 608. Subsequently, an average site-flatness value is taken by averaging all site-flatness values in step 610. It is noted that this average site-flatness value is leveled utilizing both conventional site-wise leveling and slit-by-slit leveling (which has the advantage of simulating the scanning process) as described above.

It is contemplated that the average site-flatness value calculated in this manner can be utilized to compute various derived metrics and information regarding a given wafer. For instance, by subtracting the average value from each site-based value, as shown in step 612, a site-to-site variation map can be calculated for the full wafer. It is also contemplated that while flatness values are used as exemplary measurement metrics, this site-based, slit-by-slit variation calculation process is applicable for calculation of various other types of measurement metrics, including, but not limited to flatness variations, thickness variations, as well as various other types of wafer topography variations that correlate to non-correctable focus errors seen by the lithography scanner during wafer exposure.

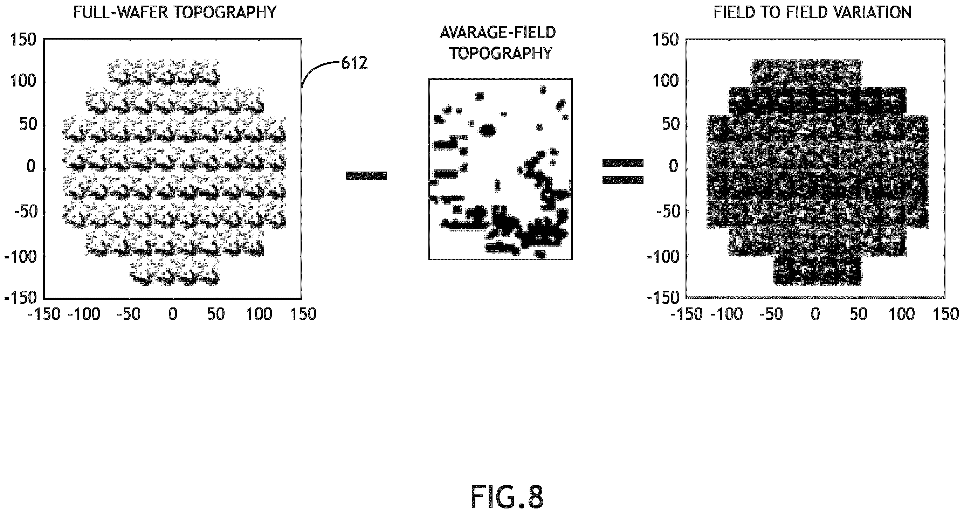

It is also contemplated that these variation maps can be used for reporting purposes, and can also be analyzed to improve the manufacturing processes. For example, in the site-to-site variation map shown in FIG. 8, the topography variation (which is systematic) coming from the device pattern is removed. Thereby any process variability (such as a local hot-spot created by a polishing tool) becomes visible after the systematic topography is removed. This information can then be provided as a feedback control to the polishing tool, thereby improving future processes.

It is further contemplated that the average-site and site-to-site variation maps and metrics are not limited to flatness measurements. The same techniques described above are also applicable to other metrics for front side and/or backside maps such front and/or back nanotopography and the like without departing from the spirit and scope of the present disclosure.

It is contemplated that while the examples above referred to polishing tools and lithography tools, the systems and methods in accordance with the present disclosure are applicable to other types of process tools, which may also benefit from the wafer geometry based control loops without departing from the spirit and scope of the present disclosure. Furthermore, the term wafer used in the present disclosure may include a thin slice of semiconductor material used in the fabrication of integrated circuits and other devices, as well as other thin polished plates such as magnetic disc substrates, gauge blocks and the like.

The methods disclosed may be implemented in various wafer geometry measurement tools as sets of instructions executed by one or more processors, through a single production device, and/or through multiple production devices. Further, it is understood that the specific order or hierarchy of steps in the methods disclosed are examples of exemplary approaches. Based upon design preferences, it is understood that the specific order or hierarchy of steps in the method can be rearranged while remaining within the scope and spirit of the disclosure. The accompanying method claims present elements of the various steps in a sample order, and are not necessarily meant to be limited to the specific order or hierarchy presented.

It is believed that the system and method of the present disclosure and many of its attendant advantages will be understood by the foregoing description, and it will be apparent that various changes may be made in the form, construction and arrangement of the components without departing from the disclosed subject matter or without sacrificing all of its material advantages. The form described is merely explanatory.

Further aspects and advantages of the invention may be appreciated from the following numbered clauses:
1. A method for monitoring and controlling a wafer polishing process, the method comprising:
   obtaining a first set of wafer geometry measurements of a wafer prior to the wafer polishing process, the first set of wafer geometry measurements including: a first front side height measurement, a first backside height measurement, and a first wafer flatness measurement;
   optimizing the wafer polishing process for the wafer, wherein different pressure levels are assigned to different areas of the wafer to achieve a best-flatness condition, wherein the best-flatness condition for the wafer is calculated based on the first front side height measurement, the first backside height measurement and the first wafer flatness measurement obtained prior to the wafer polishing process; and
   polishing the wafer based on the optimized wafer polishing process.
2. The method of clause 1, further comprising:
   obtaining a second set of wafer geometry measurements of the wafer after the wafer polishing process, the second set of wafer geometry measurements including: a second front side height measurement, a second backside height measurement, and a second wafer flatness measurement.
3. The method of clause 2, further comprising:
   comparing the second wafer flatness measurement obtained after the wafer polishing process to the calculated best-flatness condition; and
   adjusting the wafer polishing process based on the comparison.
4. The method of clause 2, further comprising:
   comparing the first front side height measurement to the second front side height measurement and comparing the first backside height measurement to the second backside height measurement; and
   assessing wafer geometry variations induced by the wafer polishing process.
5. The method of clause 4, further comprising:
   adjusting the wafer polishing process when wafer geometry variations are induced by the wafer polishing process.
6. The method of clause 1, wherein the wafer polishing process includes chemical-mechanical polishing.
7. A method for analyzing process tool induced flatness errors, the method comprising:
   obtaining wafer geometry measurements of a wafer, the wafer geometry measurements including at least: a front side height measurement and a backside height measurement;
   identifying front side wafer surface signatures based on the front side height measurement;
   identifying backside wafer surface signatures based on the backside height measurement;
   separating flatness errors induced by the front side wafer surface signatures from flatness errors induced by the backside wafer surface signatures; and
   determining whether a process tool induced flatness errors independently based on flatness errors induced by the front side wafer surface signatures and flatness errors induced by the backside wafer surface signatures.
8. The method of clause 7, wherein the wafer geometry measurements of the wafer are obtained before and after processing the wafer using the process tool.
9. The method of clause 8, wherein the front side wafer surface signatures are identified based on the front side height measurement obtained before and after processing the wafer using the process tool, and wherein the backside wafer surface signatures are identified based on the backside height measurement obtained before and after processing the wafer using the process tool.
10. A method for controlling lithography focus errors, the method comprising:
   obtaining a first set of wafer geometry measurements of a wafer prior to lithography scanning, the first set of wafer geometry measurements including: a first front side height measurement, a first backside height measurement, and a first wafer flatness measurement;
   identifying at least one wafer flatness error; and
   controlling a lithography scanner to compensate for the at least one wafer flatness error during lithography scanning.
11. The method of clause 10, wherein identifying at least one wafer flatness error further comprises:
   estimating at least one lithography chuck induced flatness error; and
   calculating a total wafer flatness error based on the least one lithography chuck induced flatness error and the first wafer flatness measurement.
12. The method of clause 11, wherein the at least one lithography chuck induced flatness error is estimated by subtracting wafer geometry of a reference wafer measured in an unchucked state from a leveling map of the reference wafer obtained from the lithography scanner when the reference wafer is chucked.
13. The method of clause 10, further comprising:
   obtaining at least one of: a focus error and a critical dimension uniformity after lithography scanning.
14. The method of clause 13, further comprising:
   determining an effectiveness of said controlling the lithography scanner to compensate for the at least one wafer flatness error during lithography scanning based on said at least one of: the focus error and the critical dimension uniformity obtained after lithography scanning ; and
   adjusting the lithography focus based on said at least one of: the focus error and the critical dimension uniformity obtained after lithography scanning.
15. A method for calculating wafer variations, the method comprising:
   obtaining a wafer-level thickness variation map;
   dividing the wafer-level thickness variation map into a plurality of uniform sized sites;
   independently leveling each site of the plurality of sites;
   further dividing each site into a plurality of rectangular areas, wherein each rectangular area generally corresponds to a slit-size of a lithography scanner;
   independently leveling each rectangular area of the plurality of rectangular areas for each site of the plurality of sites; and
   combining the plurality of rectangular areas of each site of the plurality of sites to obtain a full wafer measurement metric.
16. The method of clause 15, wherein independently leveling each site of the plurality of sites comprises fitting a single least-square best-fit plane to each site.
17. The method of clause 15, wherein independently leveling each rectangular area of the plurality of rectangular areas for each site of the plurality of sites comprises fitting a single least-square best-fit plane to each rectangular area.
18. The method of clause 15, wherein the measurement metric includes a flatness measurement metric.
19. The method of clause 18, further comprising:
   calculating an average site-flatness value based on the combined full wafer flatness measurement metric.
20. The method of clause 19, further comprising:
   subtracting the an average site-flatness value from the combined full wafer flatness measurement metric to obtain a site-to-site variation.
21. The method of clause 20, further comprising:
   providing the site-to-site variation as a feedback control to a process tool to reduce process tool induced flatness errors.

## Claims

1. A predictive modeling based focus error prediction method, comprising:
obtaining wafer geometry measurements of a plurality of training wafers;
grouping the plurality of training wafers to provide at least one training group based on relative homogeneity of wafer geometry measurements among the plurality of training wafers;
for each particular training group of the at least one training group, developing a predictive model for that particular training group utilizing non-linear predictive modeling, the predictive model establishing correlations between wafer geometry parameters and focus error measurements obtained for each wafer within that particular training group; and
utilizing the predictive model developed for a particular training group of the at least one training group to provide focus error prediction for an incoming wafer belonging to that particular training group.

2. The method of claim 1, wherein the grouping step further comprises:
calculating correlations between each pair of wafers within the plurality of training wafers to generate a pair-wise correlation matrix;
converting the pair-wise correlation matrix to a binary relationship matrix based on whether each pair-wise correlation is greater than a predetermined similarity threshold;
identifying a maximal sub matrix containing all binary values of one from the binary relationship matrix;
identifying the wafers corresponding to the identified maximal sub matrix as being in a homogenous group;
removing the identified maximal sub matrix from the binary relationship matrix; and
repeating the steps of: identifying a maximal sub matrix containing all binary values of one from the binary relationship matrix and identifying the wafers corresponding to the identified maximal sub matrix as being in a homogenous group.

3. The method of claim 2, wherein the correlations between each pair of wafers within the plurality of training wafers are calculated at least partially based on wafer flatness measurements of the plurality of training wafers.

4. The method of claim 1, further comprising:
validating the predictive model developed for a particular training group of the at least one training group prior to utilizing the predictive model for focus error prediction.

5. The method of claim 4, wherein validating the predictive model developed for a particular training group further comprises:
validating the predictive model based on at least one wafer within the particular training group; or
wherein validating the predictive model developed for a particular training group further comprises:
validating the predictive model based on at least one wafer outside of the particular training group.

6. The method of claim 1, further comprising:
providing the focus error prediction for the incoming wafer to control a wafer process tool; or
providing the focus error prediction for the incoming wafer to control a wafer process tool; and
wherein the wafer process tool is a lithography process tool.

7. The method of claim 1, wherein the non-linear predictive modeling utilizes at least one of: a neural network, a random forest, a boosted regression tree and a support vector machine.

8. The method of claim 1, wherein said grouping the plurality of training wafers is based on relative homogeneity of wafer geometry measurements among the plurality of training wafers and further based on relative homogeneity of overlay errors among the plurality of training wafers.

9. A system, comprising:
a wafer geometry measurement tool configured to obtain wafer geometry measurements of a plurality of training wafers; and
a processor in communication with the wafer geometry measurement tool, the processor configured to:
group the plurality of training wafers to provide at least one training group based on relative homogeneity of wafer geometry measurements among the plurality of training wafers;
for each particular training group of the at least one training group, develop a predictive model for that particular training group utilizing non-linear predictive modeling, wherein the predictive model establishes correlations between wafer geometry parameters and focus error measurements obtained for each wafer within that particular training group; and
utilize the predictive model developed for a particular training group of the at least one training group to provide focus error prediction for an incoming wafer belonging to that particular training group.

10. The system of claim 9, wherein to group the plurality of training wafers, the processor is further configured to:
a) calculate correlations between each pair of wafers within the plurality of training wafers to generate a pair-wise correlation matrix;
b) convert the pair-wise correlation matrix to a binary relationship matrix based on whether each pair-wise correlation is greater than a predetermined similarity threshold;
c) identify a maximal sub matrix containing all binary values of one from the binary relationship matrix;
d) identify the wafers corresponding to the identified maximal sub matrix as being in a homogenous group;
e) remove the identified maximal sub matrix from the binary relationship matrix; and
f) repeat steps d) through e).

11. The system of claim 10, wherein the correlations between each pair of wafers within the plurality of training wafers are calculated at least partially based on wafer flatness measurements of the plurality of training wafers.

12. The system of claim 9, wherein the processor is further configured to:
validate the predictive model developed for a particular training group of the at least one training group prior to utilize the predictive model for focus error prediction.

13. The system of claim 12, wherein the processor is configured to validate the predictive model based on at least one wafer within the particular training group; or
wherein the processor is configured to validate the predictive model based on at least one wafer outside of the particular training group.

14. The system of claim 9, wherein the processor is further configured to:
provide the focus error prediction for the incoming wafer to control a wafer process tool; or
wherein the processor is further configured to:
provide the focus error prediction for the incoming wafer to control a wafer process tool; and
wherein the wafer process tool is a lithography process tool.

15. The system of claim 9, wherein the processor is configured to group the plurality of training wafers to provide at least one training group based on relative homogeneity of wafer geometry measurements among the plurality of training wafers and further based on relative homogeneity of overlay errors among the plurality of training wafers.
